# EUROPEAN PATENT APPLICATION

(11) **EP 4 324 614 A1**
(43) Date of publication of application: **21.02.2024**
(21) Application number: 23191824.4
(22) Date of filing: 17.08.2023
(51) Int. Cl.: B29B 17/02, H01L 31/04

(54) **METHOD FOR PROCESSING END-OF-LIFE PHOTOVOLTAIC PANELS, AND RELATED EQUIPMENT**

(30) Priority: 19.08.2022 IT 202200017427
(71) Applicant: Tialpi S.r.l., 13900 Biella (IT)
(72) Inventor: RAMON, Lodovico, 13862 Brusnengo (Biella) (IT)
(74) Representative: Vanzini, Christian

(57) **Abstract**

Method for processing an end-of-life photovoltaic panel, wherein the method comprises the following steps:
a) by four cutting devices (121) arranged at each of the corners of the panel, cutting to split a frame (F) of the panel into four frame pieces (F'),
b) by two pairs of pushing devices (232) oriented orthogonally to each other, applying to each of the frame pieces (F') a push directed from the center towards the periphery of the panel to detach the frame pieces (F') from the panel,
c) by a horizontally movable knife (314), removing an electric connector (EC) from the panel,
d) milling and cutting the panel to remove sealant residues from the panel and to remove a head portion from the panel, respectively, and
e) subjecting the panel to a thermomechanical treatment to detach the glass from an encapsulating layer (E) of the panel.

## Description

The present invention relates generally to methods for recovering materials in decommissioned photovoltaic panels.

At present, the current mode of treatment of end-of-life photovoltaic panels is to recover the electric wires and aluminum (17 percent by weight) and then to grind the residual panel (83 percent by weight) to a centimeter-sized granulate that may be used in small part as an inert material or is destined for the landfill, as it is a mixture of glass, plastic, and silicon with no commercial value.

It should be mentioned that there are partial glass recovery techniques on the market, but without the ability to valorize it.

EP 2998038 A1 describes a method and apparatus for detaching glass from a photovoltaic panel laminate, the laminate comprising an encapsulating layer containing photovoltaic cells, a front plate of glass, and a backsheet bonded to the encapsulating layer on opposite surfaces thereof. The known method consists in heating the photovoltaic panel laminate by means of infrared heaters to bring the encapsulating layer to a working temperature of 70 to 150°C, to cause it to soften (with a temperature gradient of 5 to 35°C between the opposite faces of the laminate) and to separate the glass from the encapsulating layer heated to the working temperature.

Obviously, decommissioned photovoltaic panels must be prepared to undergo thermomechanical treatment as described in EP 2998038 A1; in particular, components such as the frame and the electric connector must be removed beforehand, which may then be subjected to other treatments for their recovery.

An object of the present invention is to provide a method for industrializing the processing of a decommissioned photovoltaic panel in order to enable the recovery, among other things, of the glass of the panel.

According to the invention, this objective is achieved by a method for processing an end-of-life photovoltaic panel, the photovoltaic panel including:
- a rectangular laminated body comprising an encapsulating layer containing photovoltaic cells, a front plate of glass and a backsheet bonded to the encapsulating layer on opposite surfaces thereof,
- a frame arranged peripherally around the laminated body, and
- an electric connector attached to a head portion of the rectangular laminated body, wherein the method comprises the following steps:
   by four cutting devices arranged at each of the corners of the laminated body, cutting to split the frame into four frame pieces,
   by two pairs of pushing devices oriented orthogonally to each other, applying to each of the frame pieces a push directed from the center towards the periphery of the laminated body to detach the frame pieces from the laminated body,
   by a horizontally movable knife, removing the electric connector from the laminated body,
   milling and cutting the laminated body to remove sealant residue from the laminated body and remove the head portion from the laminated body, respectively; and
   subjecting the so-processed laminated body to a thermomechanical treatment to detach the glass of the front plate from the encapsulating layer.

If the method according to the invention is coupled with the method described in EP 2998038 A1, the following materials may be valorized:
- electric cables, which account for 1 percent by weight;
- aluminum profiles, which account for 16 percent by weight;
- first-grade glass, which accounts for 55 percent by weight;
- second-grade glass, which accounts for 10 percent by weight.

The total valorization amounts to 82%. This leaves residue of about 17-18% by weight to be sent to a landfill.

It is also worth mentioning that 65 percent of the glass does not emerge from the treatment with an EWC code, i.e. as waste, but as an "end-of-waste" product.

Other features and advantages of the method according to the invention will become apparent from the following detailed description of an embodiment of the invention, made with reference to the accompanying drawings, which are provided for illustrative and nonlimiting purposes only, wherein
Fig. 1 is a side elevation view of a part of a plant for carrying out the method according to the invention;
Fig. 2 is a plan view of the plant in Fig. 1;
Fig. 3 is a simplified front view of a Cartesian coordinate loading robot of the plant in Fig. 1 and 2;
Fig. 4a-4c are a top view, a cross-sectional view, and a cutaway view, respectively, depicting in a simplified manner some of the reading components of the plant in Fig. 1 and 2;
Fig. 5a-5c are respectively longitudinal views at two different operational stages and a plan view depicting in a simplified manner some of the components of a first machine of the plant in Fig. 1 and 2;
Fig. 6a-6c are cross-sections in two different operational stages and a plan view, respectively, depicting in a simplified manner further components of the first machine of the plant in Fig. 1 and 2;
Fig. 7a-7d are a plan view and cutaway views in different directions, respectively, depicting in a simplified manner still further components of the first machine of the plant in Fig. 1 and 2;
Fig. 8a-8c are a plan view and different longitudinal sections, respectively, depicting in a simplified manner components of a second machine of the plant in Fig. 1 and 2,
Fig. 9a-9c are a plan view, a longitudinal section, and a cross section, respectively, depicting in a simplified manner additional components of the second machine of the plant in Fig. 1 and 2,
Fig. 10a-10d are, respectively, a plan view, a longitudinal section, and a cross section in two different operational stages depicting in a simplified manner components of a third machine of the plant in Fig. 1 and 2;
Fig. 11a-11c are a plan view, a cross section, and a longitudinal section, respectively, depicting in a simplified manner additional components of the third machine of the plant in Fig. 1 and 2;
Fig. 12a-12b are a plan view and a longitudinal view, respectively, depicting in a simplified manner components of a fourth machine of the plant in Fig. 1 and 2; and
Fig. 13a-13b are a plan view and a longitudinal view, respectively, depicting in a simplified manner additional components of the fourth machine of the plant in Fig. 1 and 2.

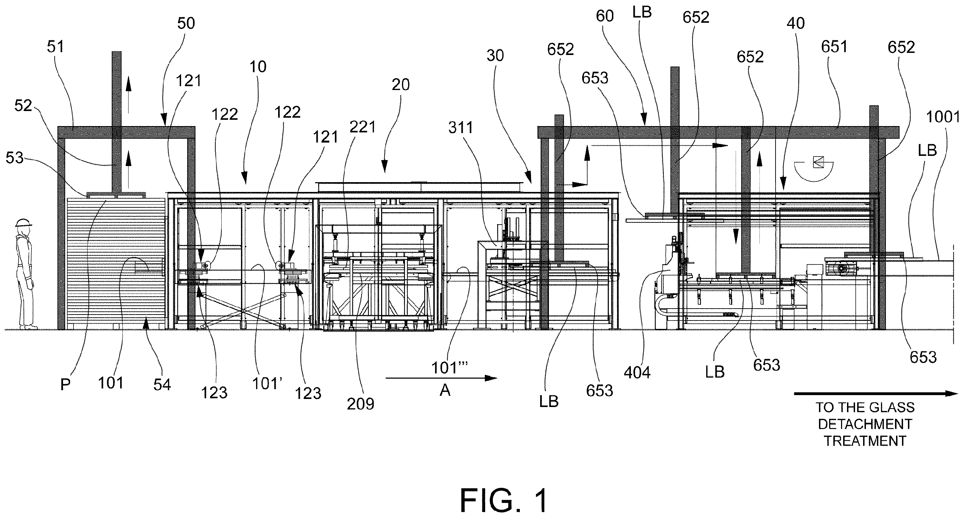

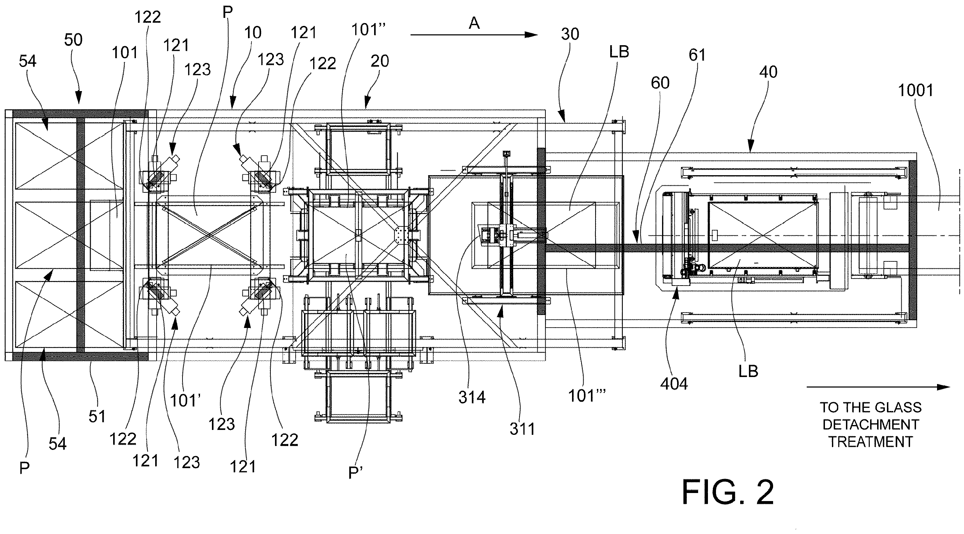

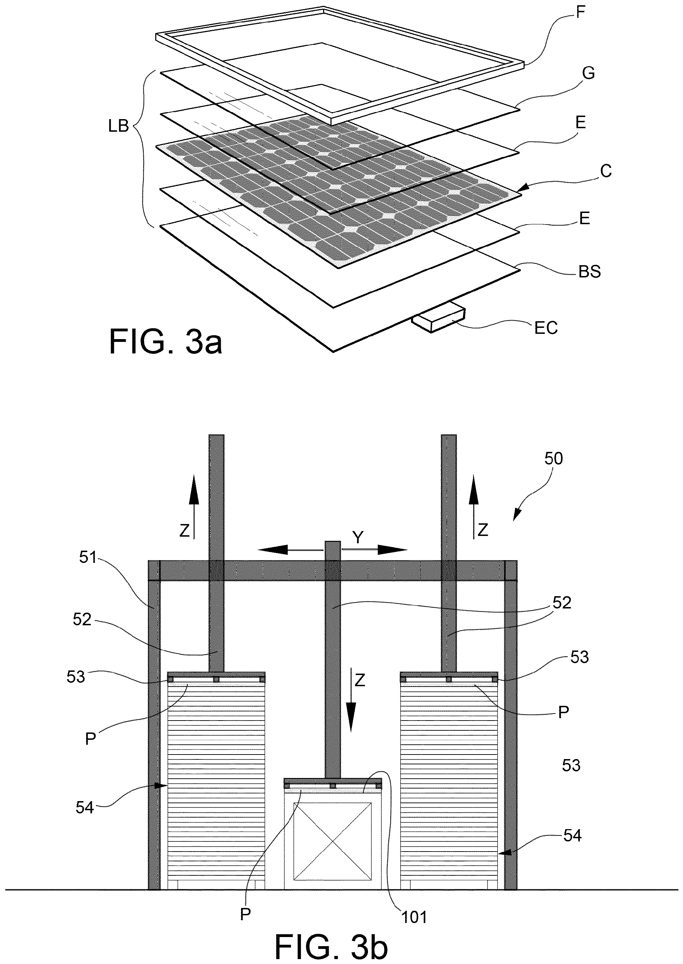

Fig. 1 and 2 show part of a plant for processing end-of-life photovoltaic panels, with the aim of recovering at least a part of the materials that make up the photovoltaic panels. The photovoltaic panels processed by the plant are of the type including (Fig. 3) a rectangular laminated body LB comprising an encapsulating layer E containing photovoltaic cells C, a front plate of glass G and a backsheet BS bonded to the encapsulating layer on opposite surfaces thereof. Generally, the encapsulating layer E consists of two layers of transparent and adhesive polymeric material bonded together, and between them is the layer of photovoltaic cells C placed side by side on the plane of the panel and connected to each other by electric connections. The encapsulating layer E is intended to hold the structure firm and provide initial physical protection to the components of the solar cell during panel assembly operations. The backsheet BS is typically a multi-layer assembly composed of polymeric material that provides additional electric insulation, moisture protection, and mechanical strength.

A frame F of metal material, usually aluminum, is also arranged peripherally around the laminated body LB to protect the assembly and facilitate its maneuverability during transport and installation in photovoltaic plants.

An electric connector EC is also attached to a head portion of the rectangular laminated body LB. This connector EC typically contains the diodes and the terminals of the internal electric circuit from which the connector cables used to connect the panel to the system circuit during the operation phase for power generation emerge.

Returning to Fig. 1 and 2, shown in particular is a plant line used to prepare decommissioned photovoltaic panels for a subsequent thermomechanical treatment station (not shown) provided to detach the front plate of glass G from the encapsulating layer E. In particular, such a thermomechanical treatment station may be configured to implement the method for separating glass from a photovoltaic panel laminate described in the publication EP 2998038 A1. The particular type of thermomechanical treatment used does not form the subject matter of the present invention.

The plant line shown in Fig. 1 and 2 essentially comprises, in succession one after another, a corner cutting station or machine 10, a frame removal station or machine 20, a connector removal station or machine 30, and a finishing station or machine 40. The plant line also comprises a first Cartesian coordinate robot 50 provided for loading the panels into the corner cutting machine 10 and a second Cartesian coordinate robot 60 for transferring processed panels from the connector removal machine 30 to the finishing machine 40 and from the finishing machine 40 to an outlet of the plant line, as described below.

Referring also to Fig. 3b, the first Cartesian coordinate robot 50 comprises a stationary support frame 21 and a loading header 52 mounted on the support frame 51 in a movable manner in a straight line along a horizontal axis y, arranged transversely to the advancement direction A of the panels along the plant line, and along a vertical axis z. The loading header 52 is equipped with a gripping device 53, such as a suction gripper with a vacuum device, by which the first Cartesian coordinate robot 50 is able to pick up an whole panel P from a magazine 54 and deposit it on a conveyor belt 101 that forms the entrance to the processing line. In the example shown, there are two magazines 54 arranged on opposite sides of the conveyor belt 101, each of which contain a plurality of stacked whole panels. Fig. 3b shows the loading header 52 both in the lateral positions in which it grasps the respective whole panel P arranged on top of each of the two magazines 54, and in the middle position in which it lays the whole panel P on the conveyor belt 101. In this description, "whole panel" means the photovoltaic panel as delivered by the end-of-life photovoltaic panel disposal companies, from which the connector wires have been cut off. Therefore, the whole panel P comprises all the components shown in Fig. 3a. It should be noted that the whole panels P stacked in the magazines 54 are arranged in such a way that the front plate of glass G faces downward.

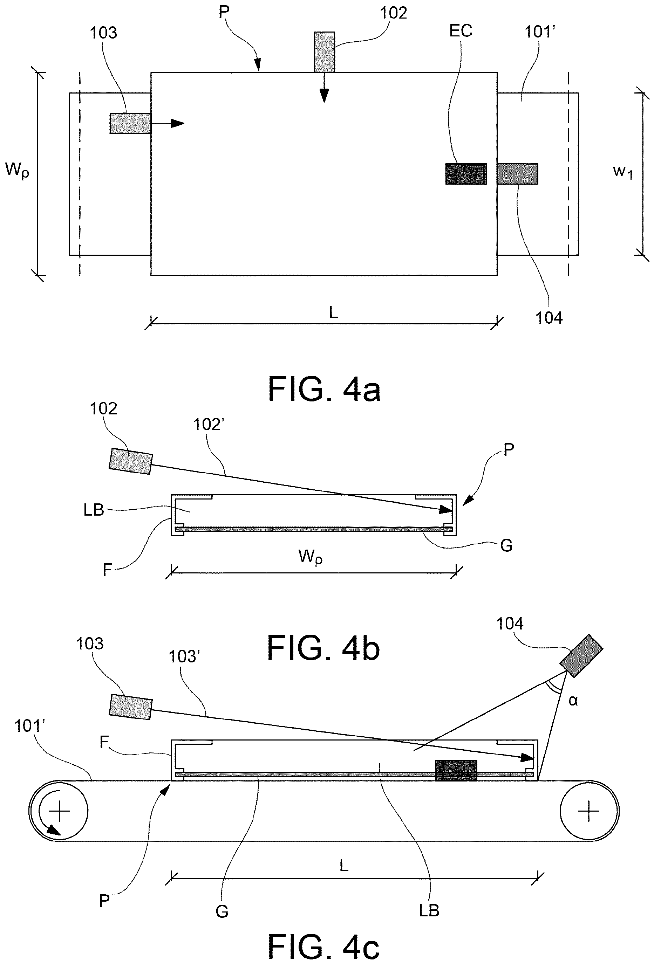

Referring to Fig. 4a-4c, the conveyor belt 101 is associated with a sensor arrangement designed to provide a data set relating to the incoming whole panel P, data that are transmitted to a plant control system to control the subsequent processing stations. In particular, the sensor arrangement comprises a first laser sensor 102, a second laser sensor 103, and a laser beam device 104. The first laser sensor 102 is arranged to emit a laser beam 102' lying in a transverse plane (orthogonal to the advancement direction of the conveyor belt 101), and is configured to measure the width Wₚ of the whole panel P (Fig. 4b). It should be noted that the width Wₚ of the whole panel P is greater than the width w₁ of the conveyor belt 101. The second laser sensor 103 is arranged to emit a laser beam 103' lying in a longitudinal plane (parallel to the advancement direction of the conveyor belt 101), and is configured to measure the length L of the whole panel P. The laser beam device 104 is arranged at the head portion of the whole panel P and is configured to detect the position of the electric connector EC in the whole panel P. In Fig. 4c, α indicates the detection angle of the laser beam device 104.

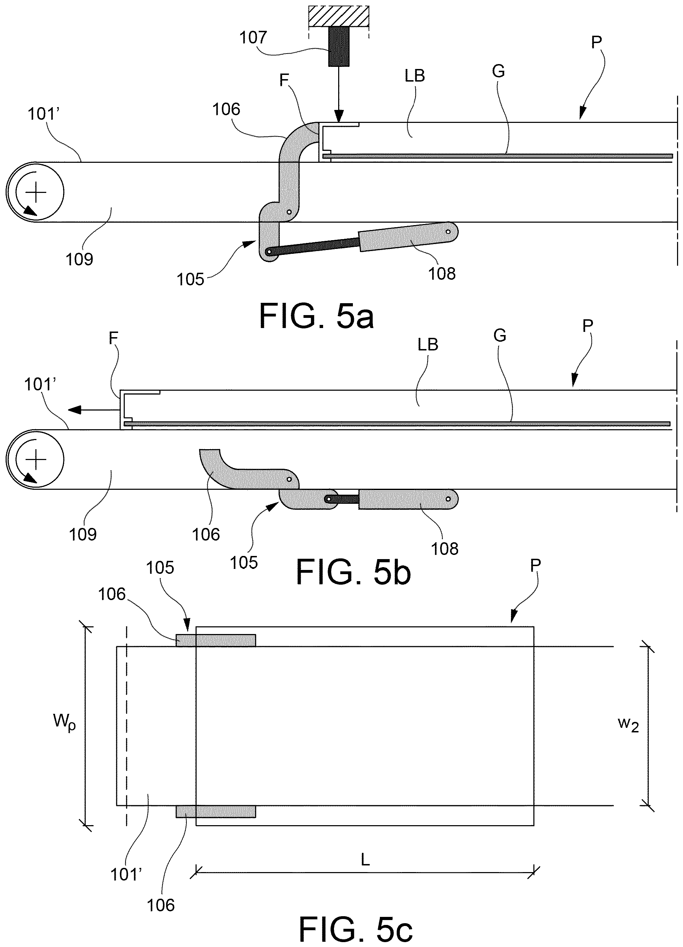

Once the measurements have been taken by the sensors 102, 103, 104, the conveyor belt 101 is started to transfer the whole panel P to a second conveyor belt 101' associated with the corner cutting station 10. The components of the corner cutting station 10 are depicted schematically in Fig. 5a-5c, 6a-6c and 7a-7d.

Fig. 5a-5c show an advancement and longitudinal positioning system of the panel for cutting. Such a system comprises a stop device 105, which comprises a stop 106 that is movable between an active position, in which the stop 106 intercepts the advancing whole panel P (Fig. 5a), and a rest position, in which the stop 106 does not interfere with the trajectory of the whole panel P (Fig. 5b). The system also comprises a photocell 107 configured to detect the arrival of the whole panel P against the stop 106 in the active position and make available a signal that triggers the conveyor belt 101' to stop. In the example shown, the stop 106 is mounted on a support structure 109 of the corner cutting station 10, and is rotatable around an axis orthogonal to the advancement direction of the conveyor belt 101'. As may be seen in Fig. 5c, the stop 106 comprises two rotatable elements integral to each other and arranged on opposite sides of the conveyor belt 101'.

This arrangement takes advantage of the fact that the width Wₚ of the whole panel P is greater than the width w₂ of the conveyor belt 101', and thus the panel protrudes laterally over the two sides of the conveyor belt. The stop device 105 further comprises a cylinder or similar linear actuator 108, the fixed part of which is mounted on the support structure of the conveyor belt 101', and the movable part of which is articulated to the stop 106 to control its movement between the rest position and the active position.

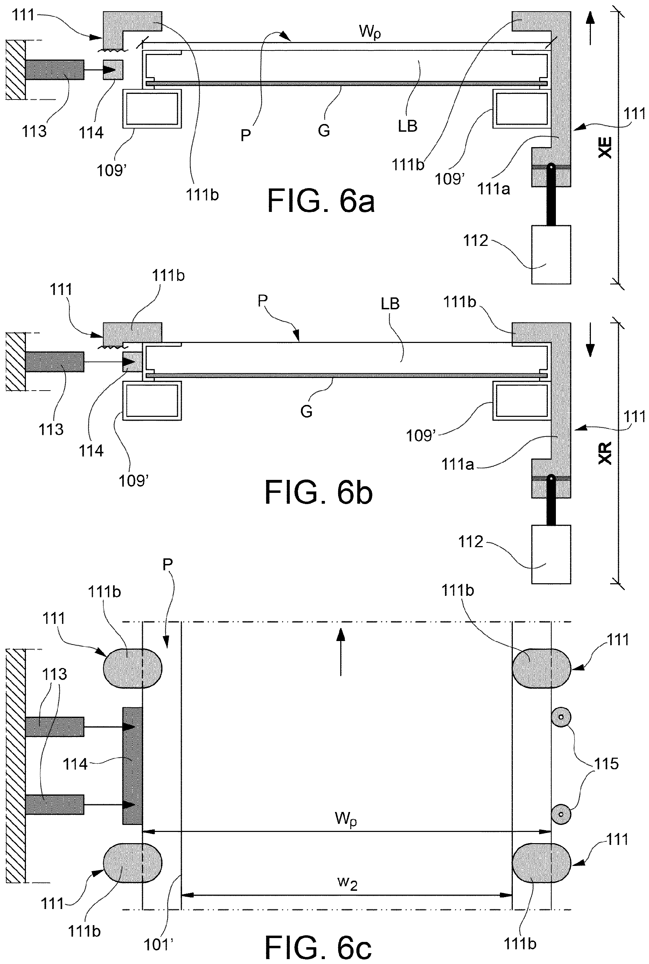

Fig. 6a-6c show a transverse panel positioning system and a panel clamping system for cutting. The clamping system comprises two pairs of retaining elements 111 arranged on opposite sides of the conveyor belt 101'. The retaining elements 111 are movable along a vertical direction between a rest position (Fig. 6a) and a clamped position (Fig. 6b). In particular, each of the retaining elements 111 comprises a main portion 111a extending vertically and arranged on a respective side of the conveyor belt 101' and a top portion 111b projecting inward above the belt. In the clamping position, the retaining elements 111 are lowered from the rest position to clamp the side edges of the whole panel P against longitudinal elements 109' of the support structure 109 of the corner cutting station 10, which are arranged on respective opposite sides of the conveyor belt 101'. A respective cylinder or other linear actuator 112 comprises a fixed part mounted on the support structure 109 of the conveyor belt 101', and a moving part connected to a respective retaining element 111 to control its movement between the rest position and the clamped position. In Fig. 6a and 6b, XE and XR denote the overall vertical extension of the actuator/retaining element assembly in the rest position and in the clamped position, respectively, with XR < XE.

The transverse panel positioning system comprises a plurality of pushing devices 113 arranged on one side of the conveyor belt 101'. Such pushing devices 113 comprise cylinders or other linear actuators, the moving part of which is arranged so that it may translate along a horizontal direction orthogonal to the advancement direction of the conveyor belt 101'. The pushing devices 113 are connected to a pad 114, which is therefore movable between a retracted position (Fig. 6a) and an extended position (Fig. 6b). In the extended position, the pushing devices 113 via the pad 114 push against the respective edge of the whole panel P inducing the abutment of the whole panel P against the main portion 111a of the retaining elements 111 arranged next to the opposite edge of the whole panel P. According to a plan view (Fig. 6c), the retaining elements 111 are arranged at the vertices of a rectangle, and the pad 114 is arranged in the center of one of the lateral sides of said rectangle. Guide rollers 115 are therefore arranged on the other side of the rectangle.

While the system depicted in Fig. 5a-5c allows the whole panel P to be positioned and stopped at the desired longitudinal position, the systems depicted in Fig. 6a-6c allow the whole panel P to be positioned at the desired transverse position and then clamped. Once clamped, the whole panel is ready for the cutting operation to be performed.

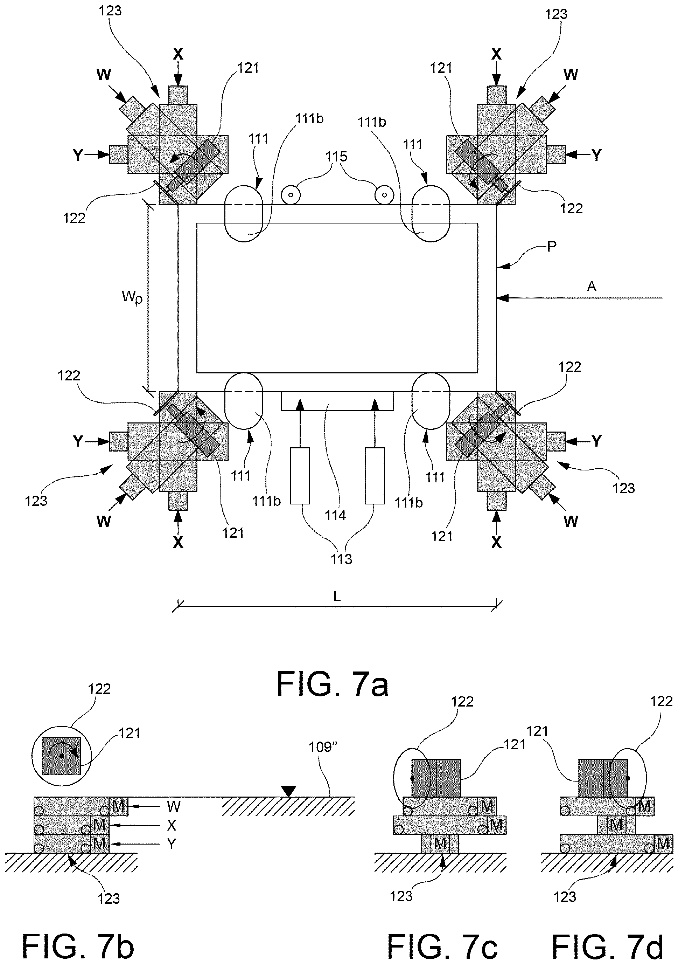

The cutting system of the corner cutting station 10 is depicted in Fig. 7a-7d, and comprises four circular saws 121 arranged at the respective four corners of the whole panel P. The circular saws 121 are arranged so that the respective rotary blades 122 lie in a vertical plane that forms a 45° angle relative to a respective side of the whole panel 45°. Each of the circular saws 121 is supported by a respective support and movement device 123, which comprises three motorized sections respectively dedicated to the movement along an axis X orthogonal to the advancement direction A of the conveyor belt 101', along an axis Y parallel to the advancement direction A of the conveyor belt 101', and along an axis W oriented at 45°, thus parallel to the plane in which the respective rotary blade 122 lies. Depending on the respective positions of the circular saws with respect to the positioning system depicted in Fig. 5a-5c and 6a-6c, it is possible to configure the respective support and movement devices 123 so that some of the respective motorized sections are activated to adjust the position of the respective circular saw according to the width and length data of the panel provided by the laser sensors 102 and 103.

In particular, with reference to the arrangement depicted in Fig. 7a:
- the circular saw 121 in the upper left has a fixed position along the axis X and along the axis Y, and a movable position along the axis W to perform the cutting of the whole panel P at the respective angle of the whole panel P;
- the circular saw 121 in the upper right has a fixed position along the axis X, a movable position along the axis Y to adjust the position of the respective rotary blade 122 with respect to the whole panel, and a movable position along the axis W to perform the cutting of the whole panel P at the respective angle of the whole panel P;

- the circular saw 121 in the lower left has a fixed position along the axis Y, a movable position along the axis X to adjust the position of the respective rotary blade 122 with respect to the whole panel, and a movable position along the axis W to perform the cutting of the whole panel P at the respective angle of the whole panel P;
- the circular saw 121 in the lower right has a movable position along the axis X and along the axis Y to adjust the position of the respective rotary blade 122 relative to the whole panel, and a movable position along the axis W to perform the cutting of the whole panel P at the respective angle of the whole panel P.

Fig. 7a shows the positioning of the cutting devices 121 relative to the support level of the panel P, corresponding to the upper face of the longitudinal elements 109' shown in Fig. 6a and 6b.

In the following, the whole panel in which the cuts were made on the corners will be called the "cut panel" and designated by the reference P'.

Using the cutting station 10 described above, it is then possible to make a cut at each of the corners of the whole panel P, so as to separate the frame into four frame pieces.

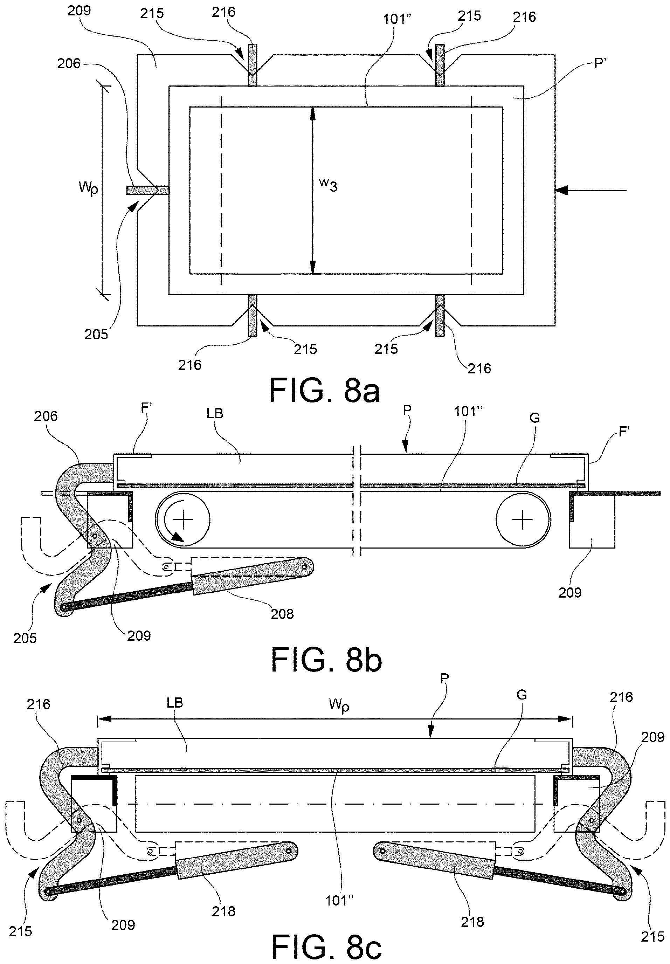

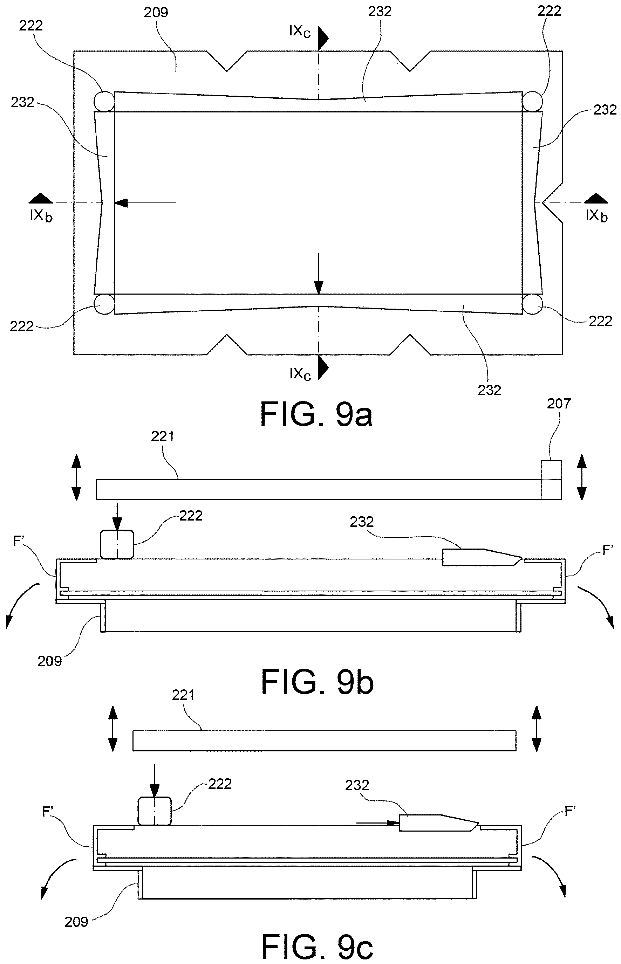

Once the cut is made, the retaining elements 111 are raised to the rest position depicted in Fig. 6a, the pushing devices are retracted to the position depicted in Fig. 6a, and the stop 106 is lowered to the position depicted in Fig. 5b. The conveyor belt 101' is then reactivated to transfer the cut panel P' to a third conveyor belt 101" associated with the frame removal station 20. The components of the frame removal station 20 are shown schematically in Fig. 8a-8c and 9a-9c.

Fig. 8a-8c show a system for advancing the panel on the belt and positioning the panel for profile detachment, and a system for centering the panel. The advancement and positioning system comprises a stop device 205, which comprises a stop 206 movable between an active position, in which the stop 206 intercepts the advancing cut panel P' (represented as a solid line in Fig. 8b) and a rest position, in which the stop 206 does not interfere with the trajectory of the cut panel P' (represented as a dashed line in Fig. 8b). The system also comprises a sensor 207 preferably of the laser type (see Fig. 9b, where the sensor 207 is shown in association with an upper structure 221) configured to detect the arrival of the cut panel P' against the stop 206 in the active position and to provide a signal that triggers the conveyor belt 101" to stop. In the example shown, the stop 206 is mounted on a base platform 209 arranged around the conveyor belt, and is rotatable around an axis orthogonal to the advancement direction of the conveyor belt 101". The stop device 205 further comprises a cylinder or similar linear actuator 208, the fixed part of which is mounted on the base platform 209, and the moving part of which is articulated to the stop 206 to control the movement thereof between the rest position and the active position. In Fig. 8a, w₃ denotes the width of the conveyor belt 101", which is smaller than the width Wₚ of the panel.

The centering system (Fig. 8c) comprises two pairs of retaining devices 215 placed on the base platform 209 on opposite sides of the conveyor belt 101". Each of the retaining devices 215 comprises a retaining element 216 that is movable between an active position, in which the retaining element 216 engages a side edge of the cut panel P' (shown as a solid line in Fig. 8c), and a rest position, in which the retaining element is lowered (shown as a dashed line in Fig. 8c). In the example shown, the retaining elements 216 are rotatable around respective axes parallel to the advancement direction of the conveyor belt 101". The retaining devices 215 also comprise respective cylinders or similar linear actuators 218, the fixed part of which is mounted on the base platform 209, and the moving part of which is articulated to the respective retaining element 216.

Once the cut panel P' comes to rest against the stop 206 in the active position, the conveyor belt 101" is stopped and the retaining elements 216 are raised to the active position to perform the centering of the cut panel P' with respect to the base platform 209. The stop 206 and the retaining elements 216 are then lowered to the rest position.

Fig. 9a-9c show a panel clamping system and a frame piece detachment system (for simplicity, the conveyor belt is not shown in these figures). These systems are carried by an upper structure 221 arranged above the base platform 209 and movable along a vertical direction relative to the base platform 209. This upper structure 221 is lowered onto the cut panel P' to allow the systems carried thereby to operate. The clamping system comprises four pads 222 adapted to be placed at respective corners of the cut panel P'. These pads 222 are movable along a vertical direction relative to the upper structure 221, being carried by respective cylinders or movable actuators not shown, arranged on board the upper structure 221. These pads 222 are adapted to exert a clamping action on the cut panel P', against the base platform 209. It should be noted that the width and length of the cut panel P' are greater than the width and length of the conveyor belt 101" respectively; therefore, a peripheral portion of the cut panel P' is able to rest on the base platform 209.

The detachment system comprises four pushing elements 232 adapted to be arranged at respective sides of the cut panel P'. These pushing elements 232 are movable along a horizontal direction relative to the upper structure 221, being carried by respective cylinders or movable actuators, not shown, arranged on board the upper structure 221. These pushing elements 232 are adapted to exert a pushing action on the frame pieces F' in the outward longitudinal direction (Fig. 9b) and in the outward transverse direction (Fig. 9c), respectively, to cause them to detach from the cut panel P' and to fall beyond the outer periphery of the base platform 209. The frame removal station 20 is thus associated with wheeled magazines for collecting the detached frame pieces F'. As may be seen in Fig. 9a, the pushing elements 232 have a tapered profile from the ends toward the center, which facilitates the detaching action exerted thereby.

In the following, the panel from which the frame pieces F1 have been removed will be called the "laminated body" and designated with the reference LB used previously.

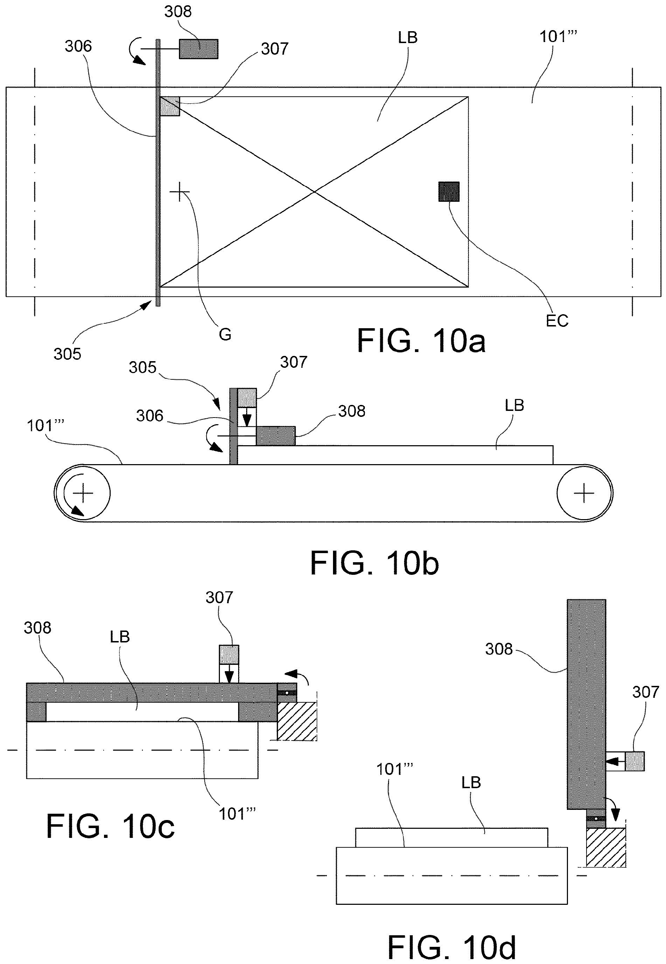

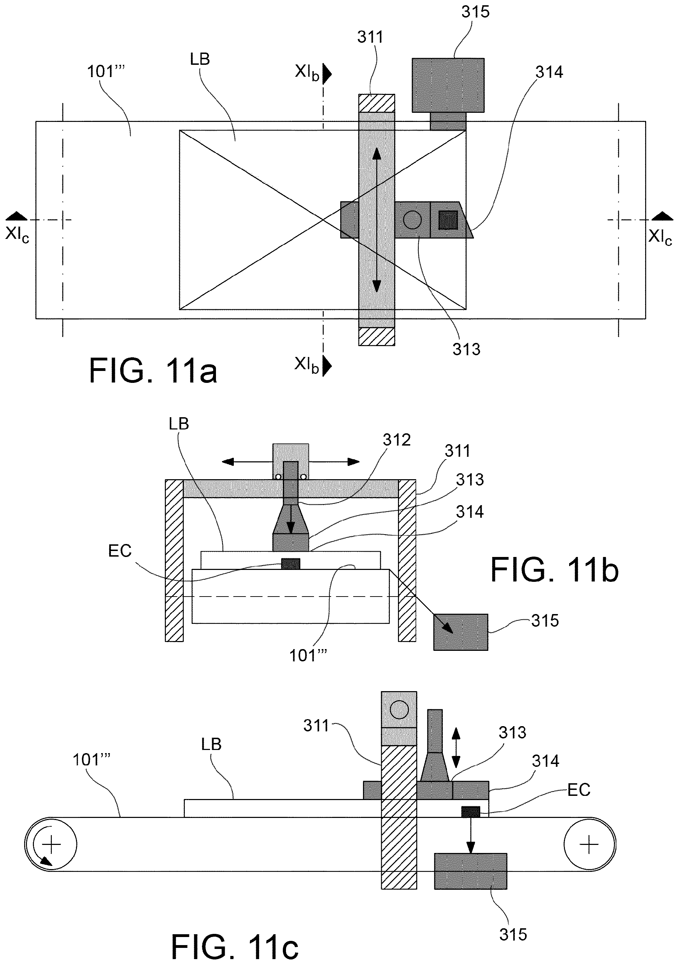

Once the frame has been removed, the upper structure 221 is raised. The conveyor belt 101" is then reactivated to transfer the laminated body LB to a fourth conveyor belt 101‴ associated with the connector removal station 30. The components of the connector removal station 30 are depicted schematically in Fig. 10a-10d and 11a-11c.

Fig. 10a-10d depict a system for clamping and advancing the panel on a belt. The clamping and advancing system comprises a stop device 305, which comprises a stop bar 306 that is movable between an active position, in which the stop bar 306 intercepts the advancing laminated body LB (Fig. 10a-10c), and a rest position, in which the stop bar 306 does not interfere with the trajectory of the laminated body LB (Fig. 10d). The system also comprises an optical sensor 307 configured to detect the arrival of the laminated body LB against the stop bar 306 in the active position and provide a signal that triggers the conveyor belt 101‴ to halt. In the example shown, the stop bar 306 is mounted on a support structure associated with the conveyor belt, and is rotatable around an axis parallel to the advancement direction of the conveyor belt 101‴. The stop device 305 further comprises an actuator 308 to control the movement of the stop bar between the raised rest position and the lowered active position.

Fig. 11a-11c depict a cutting and magazine loading system of the connector; for simplicity, the stop bar 306 is not shown in these figures. The aforesaid system comprises a bridge structure 311 arranged astride the conveyor belt 101‴, and along a horizontal guide of which a movable support 312 is able to slide. A cutting head 313 equipped with a knife 314 is mounted on a lower end of the movable support 312. The cutting head 313 is able to translate vertically relative to the movable support 312.

Based on the data relating to the position of the connector, provided by the laser beam device 104 depicted in Fig. 4a-4c, the cutting system positions the knife 314 alongside the electric connector EC protruding upward from the backsheet BS of the laminate body LB. The cutting system then moves the knife 314 in the transverse direction to locate the connector EC and cuts it by moving flush with the laminate body LB in the longitudinal direction and then removes the electric connector EC, finally pushing it to a storage magazine 315 arranged along the conveyor belt 101‴ where it will fall by gravity.

Referring to Fig. 1 and 2, the second Cartesian coordinate robot 60 is described, which transfers laminated bodies LB from the connector removal machine 30 to the finishing machine 40, and from the finishing machine 40 to an outlet of the plant line.

The second Cartesian coordinate robot 60 comprises a stationary support frame 651 and a loading header 652 mounted on the support frame 21 in a movable manner in a straight line along a horizontal axis, arranged parallel to the advancement direction A of the panels along the plant line, and along a vertical axis z. The loading head 652 is also rotatable by 180° around the vertical axis z. The loading header 652 is equipped with a gripping device 653, for example, a suction gripper with a vacuum device, through which the second Cartesian robot 60 is able to pick up the laminated body LB from the connector removal station 30 to the finishing machine 40, and from the finishing machine 40 to an outlet of the plant line. Fig. 2 depicts the loading header 652 in the position wherein it is lowered to grasp the laminated panel LB in the connector removal station 30, in an intermediate position while traveling from the connector removal station 30 to the finishing station 40, and finally in the position wherein it is lowered to lay down the laminated body at the outlet of the plant line. Fig. 10a shows the position G of the center of gravity of the gripping device 653 when said device grips the laminated body LB.

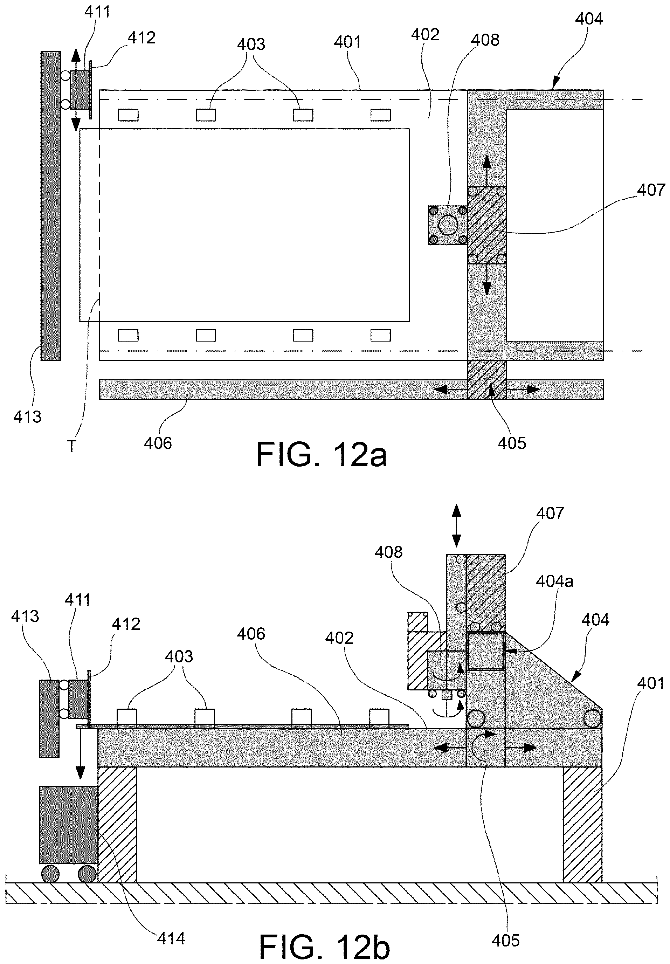

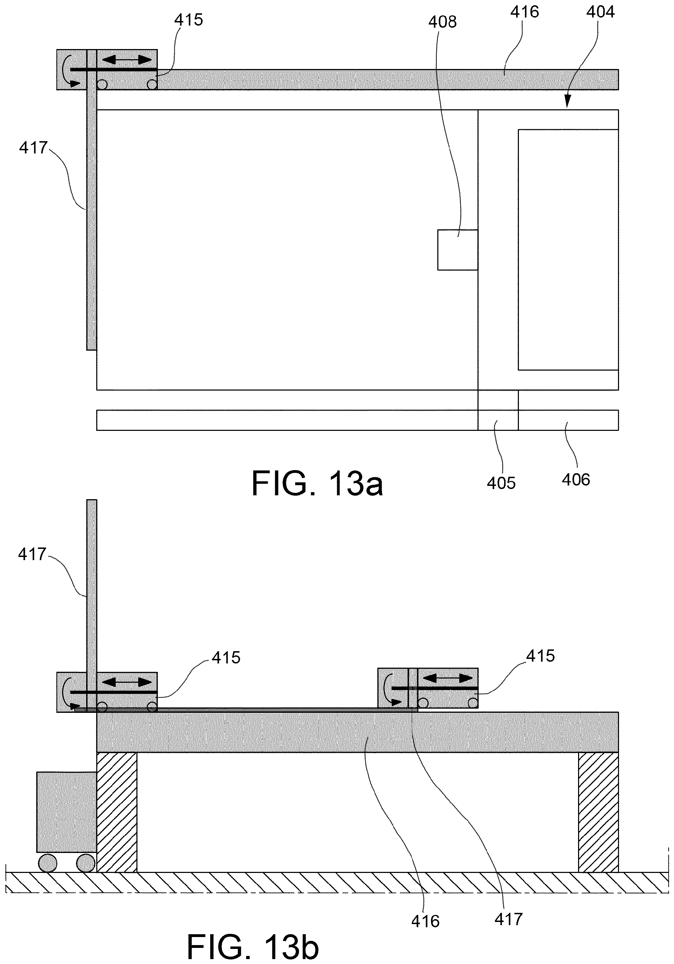

The second Cartesian coordinate robot 60 then transfers the laminated body LB from the connector removal station 30 to the finishing station 40. Once the laminated body LB is picked up from the connector removal station 30, the stop barrier 306 is raised and the conveyor belt 101‴ is started. When transferring from the connector removal station 30 to finishing station 40, the laminated body is rotated 180° around a vertical axis. The components of the finishing station 40 are depicted in Fig. 12a-12b and 13a-13b.

Fig. 12a-12b depict a milling system of the surface of the backsheet BS, and a cutting system of the head portion of the laminated body LB. The finishing station 40 comprises a base platform 401, on an upper surface of which is obtained a loading plane 402 adapted to receive the laminated body LB. The loading plane 402 is equipped with movable hooks 403 that are operable to clamp the laminated body LB. The milling system comprises a bridge structure 404 arranged on the loading plane 402 and able to move along a longitudinal direction of the loading plane 402. For this purpose, a motorized carriage 405 integral therewith and operable to translate along a longitudinal truss 406 arranged parallel to the longitudinal side of the loading plane 405 is associated with the bridge structure 404. A support column 407 is mounted on a transverse truss 404a of the bridge structure 404, which is able to translate in the transverse direction along the transverse truss 404a. At the lower end of the support column 407A a milling head 408 is arranged, which is able to translate vertically relative to the support column 407. The milling head 408 is equipped with a rotary milling tool 409. The above-described milling system is operable to remove sealant residues from the backsheet BS of the laminated body LB, present in particular at the peripheral area of the backsheet BS where the frame F was present.

The cutting system comprises a header 411 movable in the transverse direction along a guide 413 arranged parallel to a transverse side of the loading plane 402. The header 411 is equipped with a motorized saw 412 that is operable to cut the head portion of the laminated body LB, arranged to protrude beyond the transverse side of the loading plane 402. The cut line is represented by the dashed line T in Fig. 12a. Below this area, a container 414 for collecting fallen header strips is arranged. The cutting system is used to remove the head portion of the laminated body LB, opposite to the tail portion where the electric connector EC was arranged. By removing a panel strip, for example, of about 25-30 mm, such a system ensures that the front edge section of the panel is "virgin," meaning that there is no presence in the header of sealants that could compromise the action of the next treatment station.

The laminated body LB treated at the finishing station 40 is then picked up by the second Cartesian coordinate robot 60 and positioned at the outlet of the plant line described above, on a fifth conveyor belt 1001 configured to transfer the laminated body LB to a thermomechanical treatment station (not shown) provided to detach the front plate of glass G from the encapsulating layer E. Such a thermomechanical treatment station may be configured to implement the method for separating glass from a photovoltaic panel laminate described in the publication EP 2998038 A1.

Fig. 13a and 13b depict a cleaning system, comprising a motorized carriage 415 operable to translate along a longitudinal truss 416 arranged parallel to the longitudinal side of the loading plane 405, on the side opposite that along which the longitudinal truss 406 of the milling system is arranged. A bar 417 equipped with a brush is placed on the motorized carriage 415, which is rotatable around an axis parallel to the longitudinal direction, between a raised rest position (depicted on the left in Fig. 13b) and an active lowered position (depicted on the right in Fig. 13b and Fig. 13a). The bar 417 is controlled in rotation by an actuator not shown. The carriage 415, which moves from one end of the laminate body LB to the other with the bar 417 lowered, makes a sliding contact that allows it to sweep the loading plane 402 and push any residues toward the end where the collection container 414 is positioned. The cleaning system of the work surface is used to remove glass residue that may come off the laminated body LB during milling.

## Claims

1. Method for processing an end-of-life photovoltaic panel, the photovoltaic panel including:
- a rectangular laminated body (LB) comprising an encapsulating layer (E) containing photovoltaic cells, a front plate of glass (G) and a backsheet (BS) bonded to the encapsulating layer (E) on opposite surfaces thereof,
- a frame (F) arranged peripherally around the laminated body (LB), and
- an electric connector (EC) attached to a head portion of the rectangular laminated body (LB),
wherein the method comprises the following steps:
a) by four cutting devices (121) arranged at each of the corners of the laminated body (LB), cutting to split the frame (F) into four frame pieces (F'),
b) by two pairs of pushing devices (232) oriented orthogonally to each other, applying to each of the frame pieces (F') a push directed from the center towards the periphery of the laminated body (LB) to detach the frame pieces (F') from the laminated body (LB),
c) by a horizontally movable knife (314), removing the electric connector (EC) from the laminated body (LB),
d) milling and cutting the laminated body (LB) to remove sealant residues from the laminated body (LB) and remove the head portion from the laminated body (LB), respectively, and
e) subjecting the so-processed laminated body (LB) to a thermomechanical treatment to detach the glass of the front plate (G) from the encapsulating layer (E).

2. Method according to claim 1, comprising, before step a):
by first sensors (102, 103), providing data of length and width of the photovoltaic panel, and
by a second sensor (104), detecting the position of the electric connector relative to the photovoltaic panel.

3. Method according to claim 2, wherein the step a) comprises:
transporting the photovoltaic panel (P) by a conveyor belt (101, 101'),
by a switchable stop device (105), stopping the photovoltaic panel (P) in a predetermined longitudinal position,
detecting abutment of the photovoltaic panel (P) against the stop device (105) and triggering the conveyor belt (101, 101') to halt,
by lateral pushing devices (113), placing the photovoltaic panel (P) in a predetermined transverse position,
clamping the photovoltaic panel (P), and
placing the four cutting devices (121) at each of the corners of the laminated body (LB) based on the data of width and length provided by the first sensors (102, 103).

4. Method according to claim 3, further comprising
by a Cartesian coordinate robot (50), loading the photovoltaic panel (P) on the conveyor belt (101, 101').

5. Method according to claim 3 or 4, wherein step b) comprises:
transporting the photovoltaic panel (P') by a second conveyor belt (101"),
by a switchable stop device (205), stopping the photovoltaic panel (P') in a predetermined longitudinal position,
detecting abutment of the photovoltaic panel (P') against the stop device (205) and triggering the conveyor belt (101") to halt,
by lateral retaining devices (215), placing the photovoltaic panel (P) in a predetermined p transverse position,
clamping the photovoltaic panel (P), and
placing the two pairs of pushing devices (232) at the four sides of the laminated body (LB) based on the data of width and length provided by the first sensors (102, 103).

6. Method according to claim 5, wherein the step c) comprises:
transporting the laminated body (LB) by a third conveyor belt (101‴),
by a switchable stop device (305), stopping the laminated body (LB) in a predetermined longitudinal position,
detecting abutment of the laminated body (LB) against the stop device (305) and triggering the conveyor belt (101‴) to halt,
by first movement means (311, 312, 313), placing the knife (314) beside the electric connector (EC) based on the data of position provided by the second sensor (104).

7. Method according to claim 6, wherein the step d) comprises:
clamping the laminated body (LB) on a loading plane (402),
by second movement means (404, 405, 407, 408), passing a rotating milling tool (409) over an upper surface of the laminated body (LB),
by a transversely movable cutting device (411, 412), cutting the head portion of the laminated body (LB).

8. Method according to claim 6, further comprising
by a second Cartesian coordinate robot (60), transferring the laminated body (LB) from the third conveyor belt (101‴) to the loading plane (402).

9. Plant configured to carry out a method according to any of the preceding claims.
